# EUROPÄISCHE PATENTANMELDUNG

(11) **EP 1 033 753 A2**
(43) Veröffentlichungstag der Anmeldung: **06.09.2000**
(21) Anmeldenummer: 00103879.3
(22) Anmeldetag: 24.02.2000
(51) Int. Cl.: H01L 27/105

(54) **Halbleiterspeicheranordnung mit Dummy-Bauelementen auf durchgehenden Diffusionsgebieten**

(30) Priorität: 24.02.1999 DE 19907921
(71) Anmelder: Infineon Technologies AG, 81541 München (DE)
(72) Erfinder: Chrysostomides, Athanasia, 81929 München (DE); Savignac, Robert, Dr., 85737 Ismaning (DE); Feurle, Robert, 85579 Neubiberg (DE); Schneider, Helmut, 80993 München (DE)
(74) Vertreter: Zedlitz, Peter, Dipl.-Inf.

(57) **Zusammenfassung**

Die Erfindung betrifft eine Halbleiterspeicheranordnung mit wenigstens zwei Speicherzellenfeldern, bei der in der freien Fläche (4) zwischen den Streifen der Sense-Amp-Transistoren (1) der beiden Speicherzellenfelder Dummy-Transistoren (3) vorgesehen sind, um an Rändern (2) der an diese freie Fläche (4) angrenzenden Sense-Amp-Transistoren (1) Nachbarschaftseffekte zu vermeiden. Die Sense-Amp-Transistoren (1) und die Dummy-Transistoren sind in einem gemeinsamen, durchgehenden Diffusionsgebiet (5) angeordnet.

## Beschreibung

Die vorliegende Erfindung betrifft eine Halbleiterspeicheranordnung mit wenigstens zwei Speicherzellenfeldern, die mit Streifen aus Leseverstärker- bzw. Sense-Amp-Transistoren und Treibern versehen sind, wobei zwischen den wenigstens zwei Speicherzellenfeldern für die Halbleiterspeicheranordnung nicht benötigte freie Flächen vorgesehen sind.

Integrierte Halbleiteranordnungen, die jeweils Dummy-Bauelemente aufweisen, sind beispielsweise aus DE 197 03 611 A1 oder US 5 796 148 A bekannt.

Bei Halbleiterspeicheranordnungen ist eine Vielzahl von Speicherzellenfeldern vorgesehen, die jeweils Streifen aus Sense-Amp-Transistoren und diesen zugeordnete Treiber haben. Zwischen benachbarten Speicherzellenfeldern gibt es dabei zum Teil nicht genutzte Bereiche oder Flächen, die durch das Design der Halbleiterspeicheranordnung bedingt sind. Diese freien Flächen bedeuten aber, daß daran angrenzende Sense-Amp-Transistoren sich in ihrer Lage von allen übrigen Sense-Amp-Transistoren unterschieden, die in dem Streifen beidseitig an andere Sense-Amp-Transistoren angrenzen. Mit anderen Worten, ein an eine freie Fläche angrenzender Sense-Amp-Transistor hat eine andere "Nachbarschaft" als gewöhnliche Sense-Amp-Transistoren.

Es hat sich nun gezeigt, daß die andere Umgebung der an freie Flächen angrenzenden Sense-Amp-Transistoren sich bei der Herstellung der Halbleiterspeicheranordnung nachteilhaft auswirkt: Diffusionsprozesse, Abscheidungen von polykristallinem Silizium für die Bildung von Gateelektroden und insbesondere auch Lithografien usw. verhalten sich an der Grenze zu freien Flächen etwas anders als Mitten in dem Streifen. Diese sogenannten "Nachbarschaftseffekte" sind zwar gering, jedoch durchaus meßbar und im Betrieb der Halbleiterspeicheranordnung störend.

Weiterhin ist bei bestehenden Halbleiterspeicheranordnungen das Diffusionsgebiet von Sense-Amp-Transistoren unter den freien Flächen unterbrochen, was bei der Herstellung dieser Halbleiterspeicheranordnungen nachteilhaft ist, da Diffusionsgebiete möglichst zusammenhängend gestaltet sein sollten, um die Herstellung zu vereinfachen.

Es ist daher Aufgabe der vorliegenden Erfindung, eine Halbleiterspeicheranordnung zu schaffen, deren Bauelemente bei der Herstellung durch Nachbarschaftseffekte möglichst wenig beeinträchtigt sind und die sich durch durchgezogene Diffusionsgebiete auszeichnet.

Diese Aufgabe wird bei einer Halbleiterspeicheranordnung der eingangs genannten Art erfindungsgemäß dadurch gelöst, daß in die freien Flächen Dummy-Bauelemente eingebracht sind, die den benachbarten Bauelementen der Speicherfelder gleichen bzw. zu diesen möglichst ähnlich sind, und daß die Dummy-Bauelemente und die benachbarten Bauelemente in einem gemeinsamen, durchgehenden Diffusionsgebiet angeordnet sind. Unter "möglichst ähnlich sein" soll verstanden werden, daß die Dummy-Bauelemente prozeßtechnisch möglichst weitgehend an die Bauelemente angeglichen sind. Bei diesen Dummy-Bauelementen handelt es sich vorzugsweise um Dummy-Transistoren. Unter den Dummy-Bauelementen bzw. den Dummy-Transistoren ist das Diffusionsgebiet benachbarter Bauelemente durchgehend, so daß beispielsweise bei Sense-Amp-Transistoren unter den Streifen von zwei benachbarten Speicherzellenfeldern ein einheitliches, durchgehendes Diffusionsgebiet entsteht. Dadurch läßt sich die Ausbeute bei der Herstellung der Halbleiterspeicheranordnung beträchtlich erhöhen. Es hat sich in überraschender Weise gezeigt, daß das gemeinsame, durchgehende Diffusionsgebiet die Strahlungsfestigkeit speziell gegenüber Alpha-Strahlung steigert.

Die Dummy-Transistoren können so angeordnet werden, daß sie eingeschaltet sind, wenn die angrenzenden Speicherzellenfelder aktiv geschaltet sind.

Damit beschreitet die Erfindung einen vom bisherigen Stand der Technik vollkommen abweichenden Weg: anstelle ein Design anzustreben, bei dem freie Flächen möglichst weitgehend vermieden werden, nimmt die Erfindung diese freien Flächen in Kauf. Sie werden aber mit Dummy-Bauelementen, insbesondere Transistoren, belegt, wodurch Nachbarschaftseffekte in den verschiedensten Ebenen bei Diffusionen, Abscheidung von polykristallinem Silizium usw. weitgehend ausgeglichen werden können. Die am Rand von freien Flächen liegenden Bauelemente haben so die gleiche Nachbarschaft wie die übrigen Bauelemente, so daß durch die Einfügung der Dummy-Bauelemente eine einheitliche Umgebung für die Bauelemente ergibt. Bei beispielsweise Streifen von Sense-Amp-Transistoren wird unter diesen ein durchgehendes Diffusionsgebiet vorgesehen.

Nachfolgend wird die Erfindung anhand der Zeichnungen näher erläutert. Es zeigen:
- Fig. 1: eine Draufsicht auf Streifen von Sense-Amp-Transistoren von zwei benachbarten Speicherzellenfeldem mit dazwischenliegenden Dummy-Transistoren nach einem ersten Ausführungsbeispiel der Erfindung und
- Fig. 2: eine Draufsicht auf Streifen von zwei benachbarten Speicherzellenfeldern mit dazwischenliegenden Dummy-Transistoren nach einem zweiten Ausführungsbeispiel der vorliegenden Erfindung.

In den Figuren werden einander entsprechende Bauteile mit den gleichen Bezugszeichen versehen.

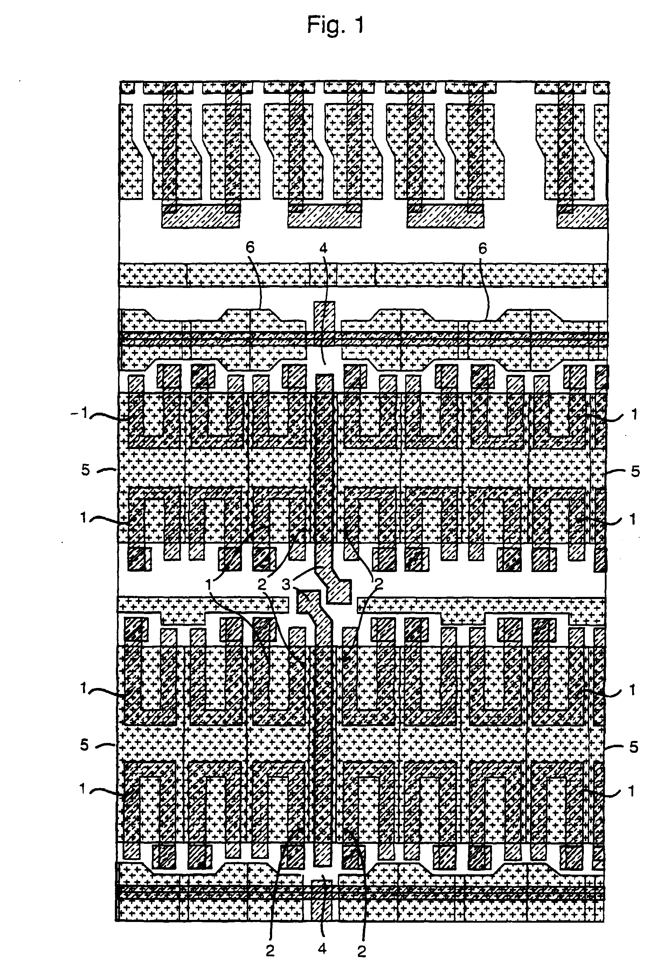

Fig. 1 zeigt Sense-Amp-Transistoren 1, die U-förmig gestaltet sind und in benachbarten Streiten nebeneinanderliegen. Zwischen den Streifen von nebeneinanderliegenden Speicherzellenfeldern ist ein freier Raum 4 vorgesehen, durch den die Sense-Amp-Transistoren 1 von zwei verschiedenen Streiten voneinander getrennt sind. Dies bedeutet, daß insbesondere an Rändern 2 der an diesen freien Raum 4 angrenzenden Sense-Amp-Transistoren 1 bei deren Herstellung Nachbarschaftseffekte auftreten, wie dies oben erläutert wurde.

Um nun diese Nachbarschaftseffekte auszuschließen, befinden sich erfindungsgemäß auf den freien Flächen 4 Dummy-Transistoren 3, die die freien Flächen 4 weitgehend ausfüllen. Dadurch werden verschiedene Vorteile erzielt:

Zunächst "sehen" die an die freien Flächen 4 angrenzenden Sense-Amp-Transistoren 1 die gleiche "Umgebung" wie alle übrigen Sense-Amp-Transistoren 1, so daß Nachbarschaftseffekte weitgehend ausgeschlossen sind. Außerdem wird ein Diffusionsgebiet 5 unterhalb der beiden jeweiligen Streifen durchgezogen bzw. durchgehend gestaltet, d.h., es wird ein einheitliches Diffusionsgebiet 5 für beispielsweise N-Typ-Sense-Amp-Transistoren bzw. P-Typ-Sense-Amp-Transistoren vorgesehen.

Den Streifen aus den Sense-Amp-Transistoren 1 sind noch Treiber 5 zugeordnet, die jeweils aus einem oder mehreren Transistoren bestehen können.

Die Dummy-Transistoren 3 können so geschaltet werden, daß sie eingeschaltet sind, wenn die jeweils benachbarten Speicherzellenfelder aktiv geschaltet sind. Sind diese Speicherzellenfelder inaktiv, so sollten auch die Dummy-Transistoren 3 ausgeschaltet sein. Damit wird erreicht, daß auch im Betrieb die Ränder 2 der an die freie Fläche 4 angrenzenden Sense-Amp-Transistoren die gleiche Umgebung "sehen" wie alle übrigen anderen Sense-Amp-Transistoren 1.

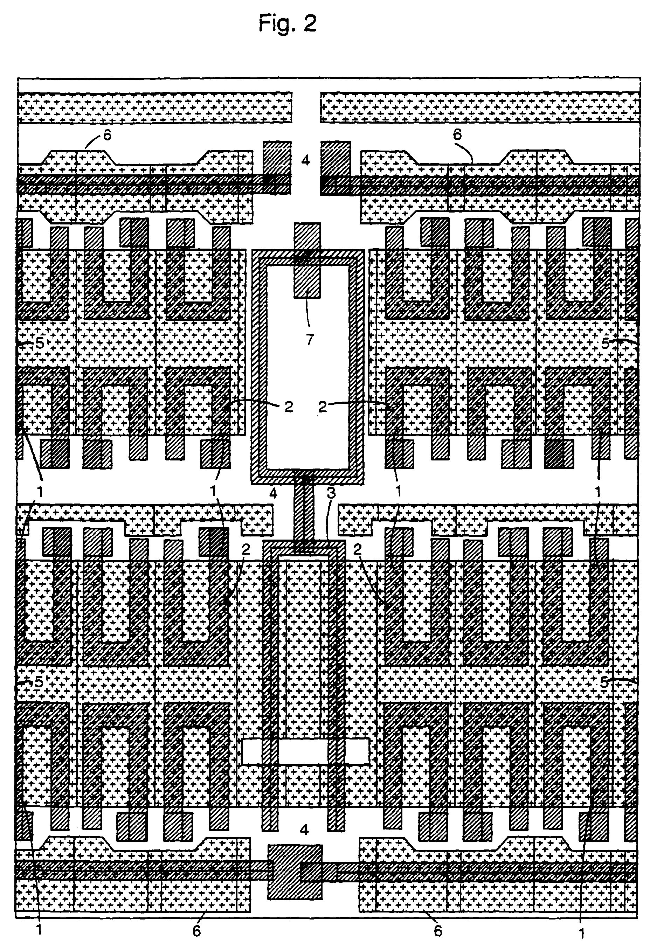

Fig. 2 zeigt in einer Draufsicht ein weiteres Ausführungsbeispiel der vorliegenden Erfindung, wobei hier der Dummy-Transistor 3 ähnlich wie die Sense-Amp-Transistoren 1 U-förmig gestaltet und mit einem großflächigen Kontaktbereich 7 versehen ist. Auch bei diesem Ausführungsbeispiel wird erreicht, daß die Ränder 2 der an die freien Flächen 4 angrenzenden Sense-Amp-Transistoren 1 praktisch die gleiche Nachbarschaft wie alle anderen Sense-Amp-Transistoren 1 "sehen", so daß die genannten Nachbarschaftseffekte ausgeschlossen werden können. Das Diffusionsgebiet 5 ist unterhalb der streifenbildenden Sense-Amp-Transistoren 1 durchgezogen bzw. durchgehend gestaltet, was die Herstellung nicht unwesentlich vereinfacht. In der rechten Hälfte von Fig. 2 wurde auf diese durchgehende Ausführung des Diffusionsgebietes 5 verzichtet, da sonst Strukturen entstehen würden, die beim verwendeten Prozeß nicht ohne weiteres fertigbar wären. Dies kann bei anderen Prozessen anders sein.

Bei der erfindungsgemäßen Halbleiterspeicheranordnung werden also in dem Bereich zwischen zwei Speicherzellenfeldern zwischen Streifen aus den Sense-Amp-Transistoren in zum Teil nicht genutzte Fläche Dummy-Transistoren eingefügt, welche bei inaktiven Speicherzellenfeldern abgeschaltet sind. Durch diese Dummy-Transistoren werden Nachbarschaftseffekte in verschiedenen kritischen Ebenen bei Diffusion, Abscheidung von polykristallinem Silizium für Gate-Erzeugung usw. weitgehend ausgeschlossen. Außerdem wird unter den Streifen ein durchgehendes Diffusionsgebiet realisiert, was die Ausbeute bei der Herstellung beträchtlich steigert und die Festigkeit bzw. Widerstandsfähigkeit gegenüber Alpha-Strahlung verbessert.

Bei den Dummy-Bauelementen handelt es sich in bevorzugter Weise wie in den obigen Ausführungsbeispielen um Transistoren. Es müssen aber nicht notwendig Transistoren sein. Vielmehr können, wenn die Umgebung der freien Flächen beispielsweise aus Dioden besteht, für die Dummy-Bauelemente gegebenenfalls auch Dioden eingesetzt werden. Wichtig ist lediglich, daß die an die freien Flächen 4 angrenzenden Ränder der jeweiligen Bauelemente die gleiche Umgebung wie alle übrigen Bauelemente sehen.

Die Sense-Amp-Transistoren 1 und die Dummy-Transistoren 3 sind in den obigen Ausführungsbeispielen jeweils MOS-Feldeffekttransistoren, wobei der Kanaltyp in jeweils einem Diffusionsgebiet 5 der gleiche ist. In den in den beiden Ausführungsbeispielen jeweils dargestellten zwei Diffusionsgebieten 5 können also für das eine Diffusionsgebiet N-Kanal-MOS-Transistoren vorgesehen werden, während in dem anderen Diffusionsgebiet 5 P-Kanal-MOS-Transistoren liegen. Entsprechend ist dann der Leitungstyp der Diffusionsgebiete 5 ebenfalls unterschiedlich.

## Patentansprüche

1. Halbleiterspeicheranordnung mit wenigstens zwei Speicherzellenfeldern, die mit Streifen aus Sense-Amp-Transistoren (1) und Treibern (6) versehen sind, wobei zwischen den wenigstens zwei Speicherzellenfeldern für die Halbleiterspeicheranordnung nicht benötigte freie Flächen (4) vorgesehen sind,
**dadurch gekennzeichnet,** daß
in die freien Flächen (4) Dummy-Bauelemente (3) eingebracht sind, die den benachbarten Bauelementen der Speicherzellenfelder gleichen bzw. zu diesen möglichst ähnlich sind, und daß die Dummy-Bauelemente und die benachbarten Bauelemente in einem gemeinsamen, durchgehenden Diffusionsgebiet (5) angeordnet sind.

2. Halbleiterspeicheranordnung nach Anspruch 1,
**dadurch gekennzeichnet,** daß
die Dummy-Bauelemente (3) durch Dummy-Transistoren gebildet sind.
